# EUROPEAN PATENT SPECIFICATION

(11) **EP 2 485 061 B1**
(45) Date of publication and mention of the grant of the patent: **16.07.2014**
(21) Application number: 12153654.4
(22) Date of filing: 02.02.2012
(51) Int. Cl.: G01R 15/18

(54) **Active core current sensor**
Aktivkernstromsensor
Capteur de courant avec noyau actif

(30) Priority: 02.02.2011 US 201113019870
(43) Date of publication of application: 08.08.2012
(73) Proprietor: Rockwell Automation Technologies, Inc., Mayfield Heights, OH 44124 (US)
(72) Inventor: Blakely, John Herman, Weaverville, NC 28787 (US)
(74) Representative: Grünecker, Kinkeldey, Stockmair & Schwanhäusser

(56) References cited:
- US-A- 4 298 838
- US-A- 4 482 862
- US-A- 5 196 784
- US-A- 5 293 121
- US-A- 5 552 979
- US-A- 5 814 983
- US-A1- 2003 062 887

## Description

### BACKGROUND

The invention relates to current sensors, and more specifically to a system and method for sensing current by allowing saturation of a core element and drawing the element out of saturation for current measurements.

Many different types and designs of current sensors have been developed and are commercially available. In certain current sensing circuits, a sensing coil is placed within a flux field of a conductor through which the current to be sensed flows. The flux, proportional to the flowing current, induces a current or a voltage in the sensing coil. A voltage across a burden resistor associated with the sensing coil can then be measured, and used as a basis for calculating the current in the conductor, the induced current being a function of the number of turns of the sensing coil. Such devices effectively define transformers in which the conductor (or conductors) forms the primary, and the sensing coil forms the secondary.

Other arrangements are available, such as ones based on Hall effect devices. In general, this type of sensor relies on the generation of a differential voltage in a semiconductor resistor that is proportional to a field produced by the current carrying conductor. Such devices often rely on a slotted ferrous toroid. An output of the Hall effect element is read as a voltage that represents the measured current through a scaling factor.

Still further arrangements are known for current sensing, including Rogowski coils and active cores. Rogowski coils operate in a manner similar to current transformers, but may be made flexible such that they can be wrapped around primary conductors without disturbing power flow. Active core arrangements rely on the control of flux in the sensing core, such as by driving it to saturation.

While such arrangements provide excellent options in many applications, they are not without drawbacks. For example, current transformers and Rogowski coils generally cannot operate to sense direct currents. Moreover, for higher currents, the cores of current transformers may saturate, rendering reliable sensing of current by conventional sensing circuits impossible. Hall effect sensors, on the other hand, may be susceptible to the effects of outside or foreign fields due to the gap in the sensing core where the semiconductive device is placed. Also, depending upon the current levels and components selected, such sensors may be more expensive than current transformers. Active core solutions generally require power to control flux, which may be considerable where saturation is desired.

Therefore, there is a need for improved current sensors and sensing circuits that are able to sense high currents, both alternating and direct currents, at reasonable costs, and in a reliable manner regardless of foreign magnetic fields that may be present in the vicinity of the sensing application.

US-A-5 293 121 relates to a current monitoring circuit for measuring direct and high duty factor currents. The current flow is magnetically sensed with a transformer having a primary winding. The transformer is driven into saturation during a first time interval and brought out of saturation during a second time interval. After the transformer is brought out of saturation an output signal is provided which is proportional to the flow of current in the conductor.

It is the object of the present invention to provide an improved sensing technique.

This object is solved by the subject matter of the independent claims.

Preferred embodiments are defined by the dependent claims.

### BRIEF DESCRIPTION

The present invention provides a novel current sensing technique designed to respond to such needs. The technique makes use of a closed magnetic path in a core, such as a high permeability material. Accuracy is maintained in the presence of foreign magnetic and electromagnetic fields, such as those of adjacent conductors. The technique may be used to measure both alternating and direct currents, and higher currents (that tend to saturate the sensing circuit core). Moreover, with little change, hardware used in the technique can be adapted to selectively operate in one manner for sensing lower currents, and in a different manner (disclosed below) for higher currents. The techniques may be used in a wide range of applications, such as microprocessor and DSP based systems. Presently contemplated applications include variable speed motor drives and other power electronic and power delivery solutions.

Briefly, according to certain embodiments of the invention, a method for sensing current through a conductor is provided. The method comprises switching a control circuit to allow a primary current through the conductor to create a flux in a closed core of a sensing coil, including flux levels that saturate the core. The control circuit is then switched to alter the flux, and a value representative of current through the sensing coil is sensed while the flux is altered. If the core is saturated, the flux may be reduced (or more generally, altered) to a level that will draw the core out of saturation to a non-saturated region, such as to a linear range of a BH hysteresis loop of the core. The value is then transformed to create a measurement of the current through the conductor.

In another embodiment, a system for sensing current through a conductor is provided. The system comprises a sensing coil wound around a closed core configured to receive the conductor therethrough, and control circuitry coupled to the sensing coil and comprising at least one switch. The control circuitry is configured to place the switch in a first conductive state to allow primary current through the conductor to create a flux in the core, including flux levels that saturate the core. The conductive state of the switch is then changed to alter the flux, such as to draw the core out of saturation if it is saturated. The system further includes measurement circuitry coupled to the control circuitry and configured to generate a signal representative of current through the sensing coil.

In another embodiment, a method for sensing current through a conductor is provided. The method comprises determining a current level to be sensed and based upon the current level, implementing a first current sensing algorithm or a second current sensing algorithm wherein the second current sensing algorithm comprises switching a control circuit to allow a primary current through the conductor to create a flux in a closed core of a sensing coil, including levels that saturate the core, switching the control circuit to alter the flux, sensing a value representative of current through the sensing coil while the flux is altered, and transforming a value representative of the current through the sensing coil to a value representative of the current through the conductor.

### DRAWINGS

These and other features, aspects, and advantages of the present invention will become better understood when the following detailed description is read with reference to the accompanying drawings in which like characters represent like parts throughout the drawings, wherein:

FIG. 1 is a block diagram of an exemplary embodiment of a current sensing system implemented according to aspects of the present techniques;

FIG. 2 is diagrammatic view of an exemplary embodiment of a sensing circuit for use in the system;

FIG. 3 is a cross section of one embodiment of a sensing circuit of FIG. 2;

FIG. 4 is a circuit diagram of first exemplary control and sampling circuitry for use in the techniques;

FIG. 5 is a graphical representation of current sampling performed via the circuitry of FIG. 4;

FIG. 6 is a circuit diagram of second exemplary control and sampling circuitry for use in the techniques;

FIG. 7 is a graphical representation of current sampling performed via the circuitry of FIG. 6;

FIG. 8 is a flow chart illustrating exemplary logic for sensing current while permitting the sensing core to saturate; and

FIG. 9 is a flow chart illustrating logic for utilizing one of two different modes for sensing current utilizing the circuitry of the preceding figures.

### DETAILED DESCRIPTION

The technique disclosed below allows for sensing currents in a transformer-type sensing arrangement that includes a closed magnetic core, which may be made of a high permeability material. The technique samples current in a secondary circuit normally when the core is not saturated (which may be in a linear region of the BH hysteresis loop of the core), and by driving the core to a non-saturated region of a BH hysteresis loop of the core when the core is saturated (which may again be in a linear region of the hysteresis loop). This in turn causes the secondary current to flow that is proportional to the primary current by a turns ratio of the transformer. A power source may be used to supply the secondary current since the core flux is driven in an opposite direction with regard to the flux induced by the primary current. In situations where the core saturates, the output signal is available only during the time when the core flux density is in a non-saturated range of the BH hysteresis loop of the core. During this time, the signal is sampled and used to determine current in the primary conductor or conductors.

In general, in presently contemplated embodiments, the system may be comprised of a current transformer, a switch or multiple switches, a sense mechanism, such as a current sense resistor, and a voltage source. The secondary of the transformer forms a series circuit with these components. The current sensing process is initiated by closing one or more switches (depending upon the circuit topology) such that the flux in the secondary opposes the flux in the primary conductor. After a brief transient period where the current ramps due to uncoupled inductance, the secondary current becomes proportional to the primary current by the turns ratio of the current transformer. In the case where a current resistor is utilized, a voltage is formed that is proportional to the primary current. A sample may be made at this time and applied to an analog-to-digital converter. The switch or switches may then be turned off and the core flux controlled by the primary current, which may again drive the core to saturation.

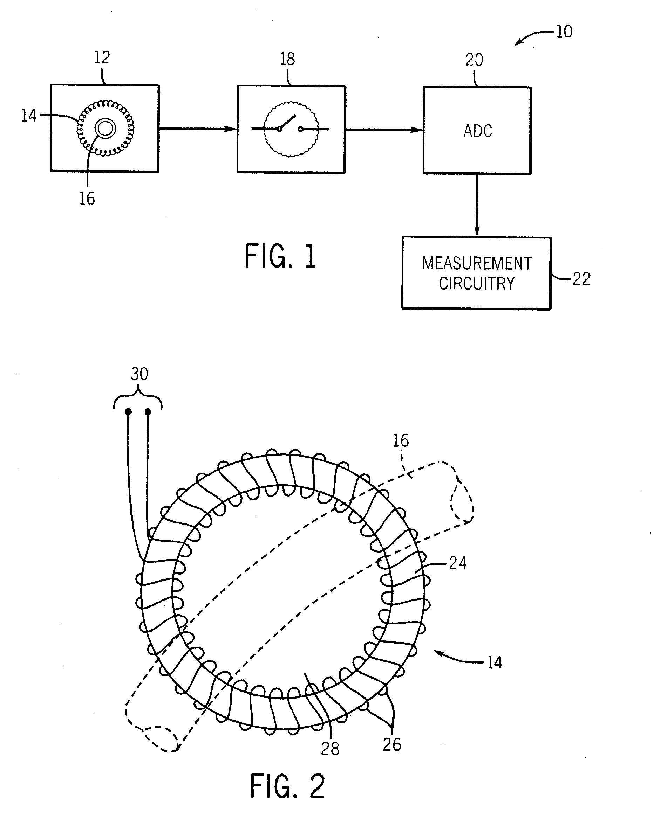

Turning now to the drawings, and referring first to FIG. 1, an embodiment of a current sensing system is shown. Current sensing system 10 is configured to sense a current in a conductor or conductors. The sensed current may be alternating current or direct current. In general, the current sensing system includes a sensing circuit 12 having a sensing coil assembly 14 for sensing current through one or more conductors 16, control circuitry 18, an analog-to-digital converter 20, and measurement circuitry 22. As best illustrated in FIG. 2, the sensing coil assembly comprises a closed, generally toroidal shaped core 24, with an aperture configured to receive the current carrying conductor 16. A sensing coil 26 is wound around the closed core and serves as a secondary of the transformer (the conductor 16 being the primary).

Control circuitry 18 is coupled to the sensing circuit 12 and includes at least one switch. As described below, currently contemplated embodiments may be based upon a monopolar control circuit configured to operate on a positive half cycle of an alternating current to be sensed. In another embodiment, the control circuitry comprises a bipolar circuit configured to operate on a positive half cycle or a negative half cycle of an alternating current. It should be noted, however, that the circuits allow for sensing direct currents through the primary conductor. Moreover, it should be borne in mind that the particular circuits described herein are intended to be exemplary only, and various sensing circuit arrangements may be utilized that operate in the manners described below.

The control circuitry is configured to place the switch or switches of the circuitry in a first conductive state to allow a primary current in the conductor to create a flux that saturates the sensing circuit. The control circuitry is further configured to change the state of the switch or switches to alter the flux in the sensing circuit to within a non-saturated range of the BH hysteresis loop of the core, so that the current in the sensing circuit can be measured.

A signal representative of a current flowing through the sensing circuit is present at the output of the control circuitry when the sensing circuit switches from a saturated state to a non-saturated state, or when the core is not saturated (i.e., already in a non-saturated range of the hysteresis loop of the core). In operation, when a measurement is to be made, a sample taken of the output of the control circuitry, and the sample is applied to the analog-to-digital converter 20. Any suitable sampling rate may be employed for this purpose, and in a presently contemplated embodiment, converter 20 samples at a nominal rate of I kHz. The sampled signal is proportional to the current in the primary conductor, such that the digitized value used by the measurement circuit 22 to calculate the current flowing through the primary conductor. Depending upon the application, the measurement circuit 22 may comprise a dedicated processor, with associated memory for storing programming and data, or may be defined as firmware or software in a processor designed to perform other functions, such as monitoring and/or control.

As described above, and as best shown in FIG. 2, the sensing circuit includes a sensing coil assembly 14 with a closed core 24 around which a sensing coil 26 is wound. The core aperture 28 allows for passage of the conductor or conductors 16 carrying current to be measured. The size, cross sectional area, number of turns, and other engineering specifications of the sensing coil assembly may be determined based upon the application and anticipated current and voltage levels of the power in the primary conductor, and their selection is within the ambit of those skilled in the art. The sensing coil 26 terminates in leads 30 that may be coupled electrically to the control circuitry as described below.

In general, the present technique may be employed with cores of various types and materials, including cores with various forms of BH hysteresis loops. In a presently contemplated embodiment, the core 28 is formed of an amorphous metal or a crystalline metal, such as steel. Such materials are available, for example, from Metglas, Inc. of Conway, South Carolina. Moreover, in this embodiment, the core comprises a square loop core. Such materials may be permitted to saturate, as described below, and may allow for use of a considerably smaller core than those used in conventional current sensors for the same current levels.

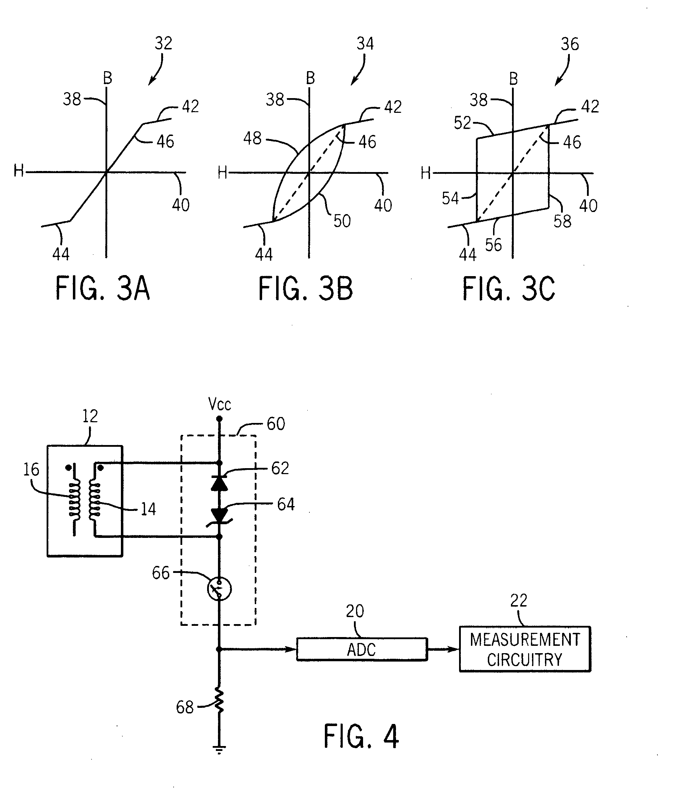

The performance of various cores, including such square loop cores may be illustrated by comparison of the relationships 32, 34 and 36 shown in FIGS. 3A, 3B and 3C, which represent exemplary hysteresis curves in which magnetic flux density B is represented along a vertical axis 38, while magnetic field strength H is represented along a horizontal axis 40. The relationship 32 illustrated in FIG. 3A is an ideal linear relationship in which upper and lower sections 42 and 44 bound a generally linear section 46 along which increases in field strength result in proportional increases in flux density. Certain type of core materials may approach or approximate such linear behavior. By comparison, in many common materials, the relationship is practically quite non-linear, as illustrated in FIG. 3B. The relationship 34 for such materials includes a saturation region 42 and different paths 48 and 50 between negative saturation and positive saturation, with a width between them related to the coercivity of the material. In square loop materials, a relationship 36 of the type illustrated in FIG. 3C may be exhibited. In such materials, as field strength is decreased from saturation of the material, as indicated by segment 52, a generally linear relationship with flux density will be observed, followed by a marked decrease, as indicated by segment 54. From the lower corner, increases in field strength will again result in generally linear increases in flux density, as indicated by segment 56, followed by a marked rise, as indicated by segment 58. In accordance with the present techniques, measurements of current in the secondary or sensing coil are made when the core is not saturated. That is, measurements may be made in region 46 if a generally linear relationship exists as illustrated in FIG. 3A, in regions 48 and 50 for cores corresponding generally to FIG. 3B, and in regions 54 and 58 of square loop cores of the type illustrated in FIG. 3C.

In the present context, where currents are sufficiently strong, the core may reach and remain in a saturated condition by relatively high fields generated by the current through the primary conductor. The core may then be pulled out of saturation and into a non-saturated region by control of the flux when measurements are to be made, allowing for sampling of output signals from the sensing coil that accurately reflect the current through the primary conductor (related by the transformer turns ratio). Once the sample is taken, the core may be permitted to return to saturation. It should be noted that in applications where the core will be saturated by the primary conductor current, no energy is required from the control circuitry to reach the saturation state. Circuits that operate by powered saturation of a core are described, for example, in U.S. patent no. 6,184,673 issued to the present inventor, Blakely, on February 6, 2001.

FIG. 4 is a schematic diagram of a current sensing system implementing a monopolar control and sampling circuit 60 (corresponding to the control circuitry 16 of FIG. 1). As noted above, the sensing coil assembly 14 forms the secondary of a transformer in which the conductor 16 carrying current to be measured forms the primary. Leads from the sensing coil assembly 14 are coupled to the control and sampling circuit 60 as illustrated. The circuit 60 in this exemplary configuration comprises a first diode 62 and a Zener diode 64 coupled as shown, and in series with a switching device 66. Any suitable switching device may be utilized, such as MOSFETs, IGBTs, and so forth. The conductive state of switching device 66 is controlled by the measurement circuitry 22 (or any processor in control of measurement). A burden resistor 68 is coupled between the switching device 66 and a known potential, such as ground. Samples are taken via the analog-to-digital converter 20, from which digital values are applied to the measurement circuitry 22. The circuit receives power (indicated by the voltage Vcc) from an external power supply (not shown).

In operation, either direct or alternating current is applied to the conductor 16, which, if producing a sufficiently strong field, may saturate the core of the coil assembly 14. The diode arrangement allows the core to fly back without excessive voltage occurring on the switching device. When measurements are to be made, the switching device 66 is closed to compete a conductive path to ground. If the core is saturated, the flux is sufficiently reduced to draw the core out of saturation, permitting sampling of a valid measurement, such as within a non-saturated range of the hysteresis loop of the core. Once the sample has been taken, the switching device 66 may be permitted to open, removing reverse flux and allowing the core to return to its unperturbed state (which may, again, be saturation).

Analog-to-digital converter 20 is coupled to the monopolar circuit 60 and is configured to sense an analog signal representative of the voltage upstream of the burden resistor. The analog signal is then converted to a digital value, and applied to the measurement circuitry 22. Based upon the turns ratio of the transformer (i.e., the number of turns of the sensing coil assembly) and the value of the burden resistor, then, the current through the primary conductor may be calculated. It should be noted that the calculation may include compensation for the magnetic characteristics of the core, and that such compensation is considerably simplified by the use of a square loop core (i.e., the absolute value of the current error term is quite small or constant).

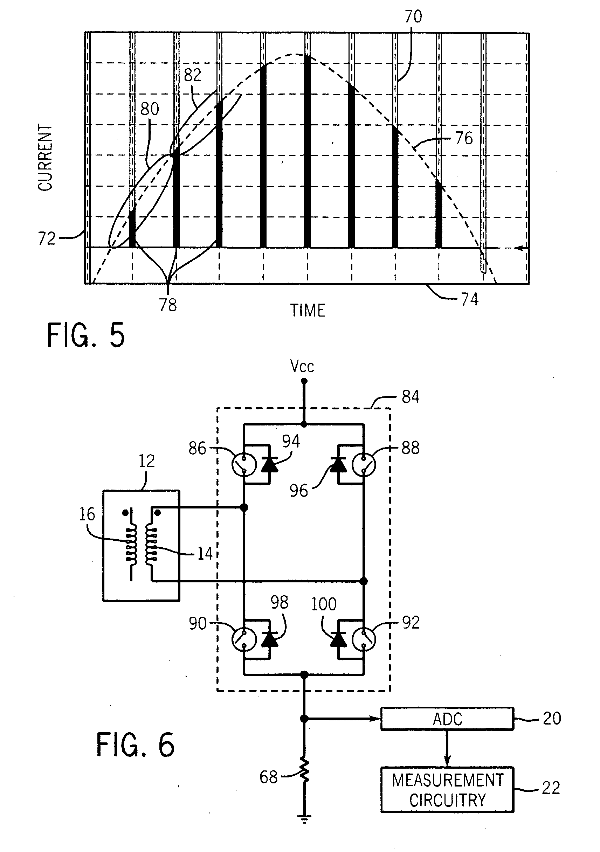

FIG. 5 is a graphical representation 70 of sampling that may be performed by the circuitry of FIG. 4. As noted, the circuitry is designed for monopolar operation, in which only either positive or negative lobes of alternating current through the primary conductor are measured. FIG. 5 illustrates a positive lobe of an sinusoidal alternating current waveform with current magnitude along a vertical axis 72 and time along a horizontal axis 74. An actual current through the primary conductor is indicated by reference numeral 76, while sampling points are indicated by reference numeral 78. In the illustration, it is assumed that the core will not saturate below some current level, as indicated by zone 80. Samples 78 taken during this zone may be made as summarized above, without drawing the core out of saturation. Such measurements are still within a non-saturated range of the core. At some current level, then, the core may saturate, as indicated by zone 82. However, the operation of the circuitry described above will draw the core out of saturation sufficiently to take valid current measurement samples. It should be noted that, while a sinusoidal alternating current waveform is illustrated in FIG. 5, waveforms of any shape may be sampled and currents calculated accordingly. Similarly, direct currents may be sensed, including currents that do not saturate the core, and currents that do saturate the core, even continuously. In all of these cases, the circuitry will act to perform current measurements either normally when the core is not saturated, or by drawing the core out of saturation if saturation occurs.

As described above, the control circuitry may also be implemented using a bipolar circuit. FIG. 6 is a schematic diagram of an exemplary bipolar circuit for performing current measurements of positive and negative lobes of changing currents (e.g., alternating currents). As illustrated, the control and sampling circuit 84 (again corresponding to the control circuitry 18 of FIG. 1) is coupled to the leads of the sensing coil assembly 14. Circuit 84 comprises switching devices 86, 88, 90 and 92 in a generally H-bridge configuration, each with respective flyback diodes 94, 96, 98 and 100. Here again, the switching devices may be of any suitable type, such as MOSFETs or IGBTs. As in the case of the monopolar circuit, the switching devices may be controlled by the measurement circuitry 22 or by any other processing circuit. Similarly, the circuit 64 receives power from an external source, as indicated by the voltage Vcc, and is coupled to the burden resistor 68 between switches 90 and 92.

In operation, the core of the sensing coil assembly 14 may remain unsaturated, or may saturate periodically or for extended periods, depending upon the components selected and the current to be sensed. For measurements, the conductive states of the switching devices are controlled. In particular, switching devices 86 and 92 are switched together, and switching devices 88 and 90 are switched together, permitting samples to be taken during both positive and negative lobes of the primary conductor current waveform. It should be noted that if the core of the sensing coil assembly is saturated by high currents during either lobe of the waveform, the circuit will pull the core out of saturation, permitting the desired measurements. The samples voltages are converted to digital values and used as the basis for current measurement calculations as discussed above.

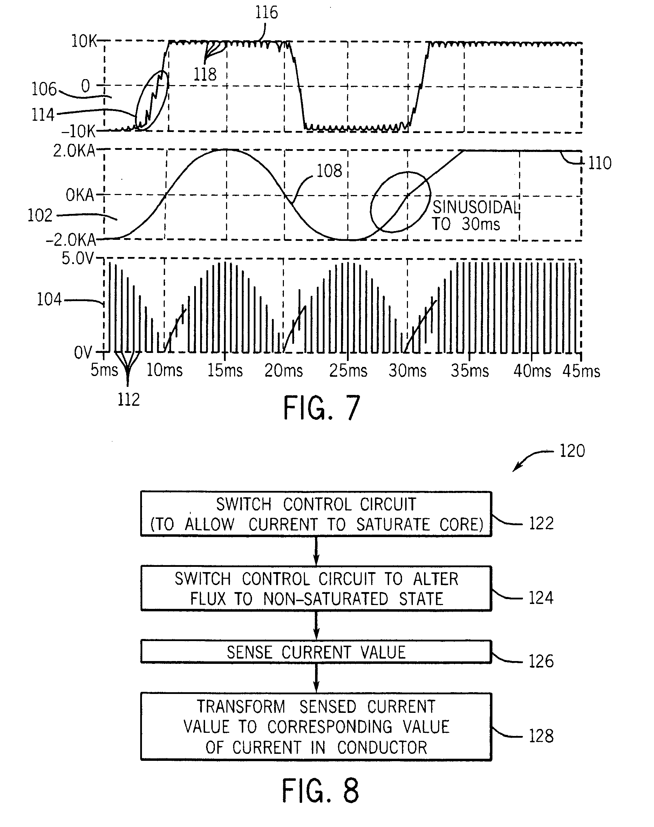

FIG. 7 is a graphical representation of current sampling and measurements made via the circuitry of FIG. 6. Reference numeral 102 designates a trace of the actual current waveform through the primary conductor, while reference numeral 104 designates current samples/measurements, and reference numeral 106 designates the flux density of the core. The actual current waveform, indicated by reference numeral 108 is, in this case, a sinusoidal alternating current waveform that becomes constant (direct current) as indicated by reference numeral 110. As indicated by reference numeral 112, the circuitry of FIG. 6 is controlled to make current measurements reflective of both the positive and negative lobes of the current waveform (indicated by absolute values in the measurements), as well as of the direct current portion of the current waveform. It may be noted that changes in frequency and amplitude of the sensed currents do not alter operation of the measurements, including when the current becomes direct. By reference to the upper graph 106, it may be noted that for lower currents (of both polarities), the flux does not saturate the core, as indicated by zone 114. Measurements may be made during such periods in exactly the same manner, however, as indicated by the "blips" in the flux. During periods of higher current, however, the core may saturate, as indicated by reference numeral 116, and such saturation may occur with both polarities. As indicated by the "blips" in the flux, however, the circuitry is effective to draw the core out of saturation sufficiently to enter into a non-saturated region in which valid measurements may be made. Here again, it should be noted that the circuitry of FIG. 6 may be used with waveforms of any shape, including currents that change polarity, currents that do not change polarity, and direct currents.

FIG. 8 is a flow chart illustrating exemplary logic for sensing current according to the above-disclosed techniques. The logic, designated generally by reference numeral 120, includes controlling the switches of the control circuitry in such a way as to permit the core to respond to the current to be sensed at step 122. In the circuitry described above, this may entail allowing the switch or switches to remain in a non-conducting state. As also noted above, this state may allow the core of the sensing coil assembly to saturate (or not), depending upon the current level through the primary conductor. At step 124 then, the conductive state(s) of one or more of the switch or switches is changed to create a flux that will draw the core out of saturation, if saturated, and that will nevertheless permit measurement if the core is not saturated. During this period, the voltage across the burden resistor is sampled, and the sensed current value represented by this voltage is detected and converted to a digital value. Finally, at step 128, the value it transformed to a sensed current value corresponding to the current through the primary conductor.

It has been found that the above described techniques are particularly well suited for measuring higher currents with smaller closed core structures than could be done in prior art arrangements, and including the ability to measure both changing polarity currents (AC) and direct currents (DC). For example, it is contemplated that techniques may be used to measure currents on the order of from 10-50 A to 2 kA and beyond.

It should also be noted that the general topology of the circuitry described above with reference to FIGS. 4 and 6 resembles relatively conventional h-and H-bridge circuits. However, such circuits have not been used in the manner described herein or with cores of the type described. The use of such circuitry, however, allows for the possibility to create current sensing devices that can operate in different manners depending upon the types and magnitudes of currents to be measured. That is, for lower currents, the circuits may be controlled in a manner that forces saturation of the core consistent with known techniques, such as that described in U.S. patent no. 6,184,673, described above. For higher currents, the circuitry may be controlled as described herein, allowing unpowered saturation of the core, with saturation being opposed for brief periods during which current measurements are made. The control circuitry described above may thus be programmed for operation in either of these modes, with selection of the particular mode being made upon configuration or commissioning of the device to which the current sensing circuitry is applied.

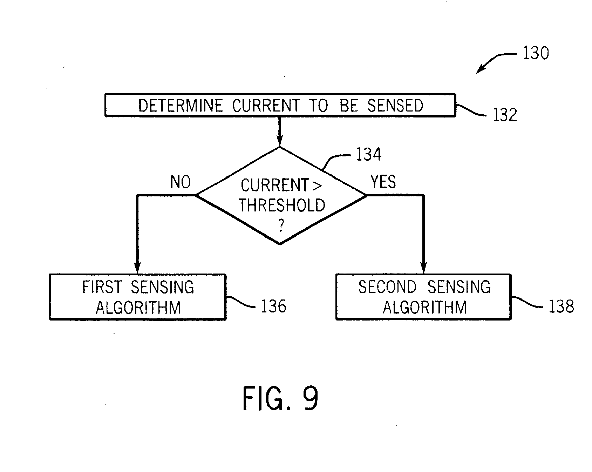

FIG. 9 is a flow chart illustrating exemplary logic for setup of the circuitry in this way. The process, designated generally by reference numeral 130, begins with determining the current levels or ranges anticipated. Based upon a predetermined threshold (indicating the distinction between "low" and "high" currents-determined generally by such factors as the components selected, their sizes and ratings), it is then decided whether the current is "low" or "high", as indicated by block 134. If the current is below the threshold (i.e., "low"), a first sensing circuit control algorithm is utilized, as indicated by step 136, such as that described in U.S. patent no. 6,184,673. On the other hand, if the current is above the threshold (i.e., "high"), a second, different control algorithm may be employed, notably that described above, as indicated by step 138

>

## Claims

1. A method for sensing current through a conductor comprising:
a) switching a control circuit to allow a primary current through the conductor to create a flux in a closed core of a sensing coil including a flux level that saturates the core, wherein the core can be brought into and out of saturation and wherein the core has a BH hysteresis loop;
b) switching the control circuit to reduce the flux to within a desired measurement level that does not saturate the core to allow a secondary current through the sensing coil that is proportional to the primary current;
c) sensing a value representative of current through the sensing coil comprising the steps of:
determining a current level to be sensed; and
based upon the current level, implementing a first current sensing algorithm or a second current sensing algorithm; and
d) transforming a value representative of the current through the sensing coil to a
value representative of the current through the conductor,
wherein the first current sensing algorithm comprises operating by a powered saturation of the core, and
wherein the second current sensing algorithm comprises operating by an unpowered saturation of the core, wherein unpowered saturation is achieved in the case the primary current is high enough to bring the core in saturation, and wherein powered saturation is achieved by forcing saturation of the core, ***in case of low primary current.***

2. The method of claim 1, wherein in step (b) the flux is reduced to within a linear range of a BH hysteresis loop of the core.

3. The method of claim 1, comprising repeating steps (a), (b), and (c) to periodically sense the current through the sensing coil.

4. The method of claim 1, comprising converting the sensed current to a digital value in an analog-to-digital converter, and wherein steps (a), (b), and (c) are performed in a time less than a sampling frequency of the analog-to-digital converter, wherein the sampling frequency is at least approximately 1 kHz.

5. The method of claim 1, wherein the control circuit is switched to allow the primary current through the conductor to saturate the core only during a portion of a period of a periodic current waveform through the conductor.

6. The method of claim 1, wherein the closed core comprises a square loop core, or wherein the closed core comprises a linear core, or wherein the closed core comprises a round loop core, or wherein the closed loop core comprises an amorphous metal core.

7. The method of claim 1,
wherein the control circuit comprises a monopolar sensing circuit, and wherein the current is sensed only one of a positive or a negative portion of a waveform of alternating current through the conductor; or
wherein the control circuit comprises a bipolar sensing circuit, and wherein the current is sensed during both positive and negative portions of a waveform of alternating current through the conductor, and further comprising changing conductive states of pairs of solid state switches of the bipolar sensing circuit depending upon whether the waveform is in a positive portion or a negative portion.

8. The method of claim 1, wherein the current to be sensed through the conductor comprises an alternating current, or wherein the current to be sensed through the conductor comprises a changing period, or wherein the current to be sensed through the conductor comprises a direct current.

9. The method of claim 1, wherein the second current sensing algorithm comprises switching a control circuit to allow a primary current through the conductor to create a flux in a closed core of a sensing coil that saturates the core, switching the control circuit to alter the flux, sensing a value representative of current through the sensing coil while the flux is altered, and transforming a value representative of the current through the sensing coil to a value representative of the current through the conductor.

10. The method of claim 9, wherein the second current sending algorithm is implemented for current levels higher than levels for which the first sensing algorithm is implemented, and/or wherein at least the second current sensing algorithm is implemented for both direct currents and alternating currents.

11. A system for sensing current through a conductor comprising:
a sensing coil wound around a closed core configured to receive the conductor therethrough, wherein the closed core has a BH hysteresis;
control circuitry coupled to the sensing coil and comprising at least one switch, the control circuitry being configured to place the switch in a first conductive state to allow primary current through the conductor to create a flux that saturates the core, and to change the state of the switch to draw the core out of saturation; and
measurement circuitry coupled to the control circuitry and configured to generate a signal representative of current through the sensing coil,
wherein the system is further configured to determining a current level to be sensed; and
based upon the current level, implementing a first current sensing algorithm or a second current sensing algorithm, wherein the first current sensing algorithm comprises operating by a powered saturation of the core, and wherein the second current sensing algorithm comprises operating by a unpowered saturation of the core, wherein
unpowered saturation is achieved in the case the primary current is high enough to bring the core in saturation, and wherein powered saturation is achieved by forcing saturation of the cores**, *in case of low primary current.***

12. The system of claim 11, wherein the control circuitry places the switch in the second conductive state to reduce the flux to within a linear range of a BH hysteresis loop of the core.

13. The system of claim 11, wherein the sensing coil comprises a square loop core, or wherein the sensing coil comprises an amorphous metal core.

14. The system of claim 11, wherein the closed core comprises a linear core, or wherein the closed core comprises a round loop core.

15. The system of claim 11, wherein the control circuitry comprises a monopolar sensing circuit configured to sense current in only one of a positive or a negative portion of a waveform of alternating current through the conductor, or wherein the control circuitry comprises a bipolar sensing circuit configures to sense current in both positive and negative portions of a waveform of alternating current through the conductor.

## Patentansprüche

1. Verfahren zum Messen eines Stroms durch einen Leiter, umfassend:
a) Schalten eines Steuerungsschaltkreises, um es einem Primärstrom durch den Leiter zu ermöglichen, einen Fluss in einem geschlossenen Kern einer Messspule, der ein Flussniveau umfasst, welches den Kern sättigt, zu erzeugen, wobei der Kern in Sättigung gebracht und aus der Sättigung heraus gebracht werden kann, und wobei der Kern eine BH-Hystereseschleife aufweist;
b) Schalten des Steuerungsschaltkreises, um den Fluss innerhalb eines gewünschten Messniveaus zu reduzieren, das den Kern nicht sättigt, um einen Sekundärstrom durch die Messspule zuzulassen, der dem ersten Strom proportional ist;
c) Messen eines Wertes, der einen Strom durch die Messspule widerspiegelt, umfassend die Schritte:
Ermitteln eines Stromniveaus, das gemessen werden soll; und
Implementieren, basierend auf dem aktuellen Niveau, eines ersten Strommessalgorithmus oder eines zweiten Strommessalgorithmus; und
d) Umwandeln eines Wertes, der den Strom durch die Messspule widerspiegelt in
einen Wert, der den Strom durch den Leiter widerspiegelt,
wobei der erste Strommessalgorithmus Operieren durch eine getriebene Sättigung des Kerns umfasst, und
wobei der zweite Strommessalgorithmus Operieren durch eine ungetriebene Sättigung des Kerns umfasst, wobei die ungetriebene Sättigung erreicht wird in dem Fall, dass der primäre Strom groß genug ist, um den Kern in Sättigung zu bringen und wobei die getriebene Sättigung erreicht wird durch Erzwingen der Sättigung des Kerns, im Fall eines niedrigen Primärstroms.

2. Verfahren gemäß Anspruch 1, wobei in Schritt b) der Fluss in einen linearen Bereich einer BH-Hystereseschleife des Kerns reduziert wird.

3. Verfahren gemäß Anspruch 1, umfassend Wiederholen der Schritte a), b) und c), um den Strom durch die Messspule periodisch zu messen.

4. Verfahren gemäß Anspruch 1, Umwandeln der gemessenen Ströme in einen digitalen Wert in einem Analog-zu-Digital-Umwandler umfassend, und wobei die Schritte a), b) und c) in einer Zeit durchgeführt werden, die kleiner ist als eine Abtastfrequenz des Analog-zu-Digital-Umwandlers, wobei die Abtastfrequenz mindestens ungefähr 1 kH beträgt.

5. Verfahren gemäß Anspruch 1, wobei der Steuerungsschaltkreis geschaltet wird, um den Primärstrom durch den Leiter zuzulassen, um den Kern nur während eines Teils einer Periode einer periodischen Wellenform durch den Leiter zu sättigen.

6. Verfahren gemäß Anspruch 1, wobei der geschlossene Kern einen quadratischen Schleifenkern umfasst, oder wobei der geschlossene Kern einen linearen Kern umfasst, oder wobei der geschlossene Kern einen runden Schleifenkern umfasst, oder wobei der geschlossene Schleifenkern einen amorphen Metallkern umfasst.

7. Verfahren gemäß Anspruch 1, wobei der Steuerungsschaltkreis einen monopolaren Messchaltkreis umfasst, und wobei der Strom nur in einem positiven oder einem negativen Teil einer Wellenform eines Wechselstroms durch den Leiter gemessen wird, oder wobei der Streuerungsschaltkreis einen bipolaren Messschaltkreis umfasst, und wobei der Strom während positiven und negativen Teilen einer Wellenform eines Wechselstroms durch den Leiter gemessen wird, und des Weiteren Ändern von Leitungszuständen von Paaren von Festkörperschaltern des bipolaren Messschaltkreises umfassend, abhängig davon ob die Wellenform in einem positiven Teil oder in einem negativen Teil ist.

8. Verfahren gemäß Anspruch 1, wobei der zu messende Strom durch den Leiter einen Wechselstrom umfasst, oder wobei der zu messende Strom durch den Leiter eine wechselnde Periode umfasst, oder wobei der zu messende Strom durch den Leiter einen Gleichstrom umfasst.

9. Verfahren gemäß Anspruch 1, wobei der zweite Strommessalgorithmus Schalten eines Steuerungsschaltkreises, um es einem ersten Strom durch den Leiter zu ermöglichen, einen Fluss in einem geschlossenen Kern einer Messspule zu erzeugen, der den Kern sättigt, Schalten des Steuerungsschaltkreises, um den Fluss zu verändern, Messen eines Wertes, der einen Strom durch die Messspule widerspiegelt, während der Fluss geändert wird, und Umwandeln eines Wertes, der den Strom durch die Messspule widerspiegelt in einen Wert, der den Strom durch den Leiter widerspiegelt, umfasst.

10. Verfahren gemäß Anspruch 9, wobei der zweite Strommessalgorithmus für Stromniveaus größer als Niveaus, für die der erste Messalgorithmuss implementiert ist, implementiert ist und/oder wobei zumindest der zweite Strommessalgorithmus für Gleichströme und Wechselströme implementiert ist.

11. System zum Messen eines Stroms durch einen Leiter, umfassend
eine Messspule, die um einen geschlossenen Kern gewickelt ist, eingerichtet, um den Leiter durch diese aufzunehmen, wobei der geschlossene Kern eine BH-Hysterese aufweist;
einen Steuerungsschaltkreis, der mit der Messspule verbunden ist und mindestens einen Schalter umfasst, wobei der Steuerungsschaltkreis eingerichtet ist, den Schalter in einen ersten Leitungszustand zu versetzen, der es ermöglicht, dass ein Primärstrom durch den Leiter einen Fluss erzeugt, der den Kern sättigt, und den Zustand des Schalters ändert, um den Kern aus der Sättigung zu ziehen; und
einen Messschaltkreis, der mit dem Steuerungsschaltkreis verbunden ist, und eingerichtet ist, ein Signal zu erzeugen, das den Strom durch die Messspule widerspiegelt,
wobei das System des Weiteren eingerichtet ist, um ein Stromniveau zu ermitteln, das gemessen werden soll, und basierend auf dem Stromniveau, Implementieren eines ersten Strommessalgorithmus oder eines zweiten Strommessalgorithmus, wobei der erste Strommessalgorithmus Operieren durch eine getriebene Sättigung des Kerns umfasst, und wobei der zweite Strommessalgorithmus Operieren durch eine ungetriebene Sättigung des Kerns umfasst, wobei die ungetriebene Sättigung in dem Fall erreicht ist, wenn der erste Strom groß genug ist, um den Kern in Sättigung zu bringen, und wobei getriebene Sättigung durch Erzwingen der Sättigung des Kerns in dem Fall eines niedrigen Primärstroms erreicht wird.

12. System gemäß Anspruch 11, wobei der Steuerungsschaltkreis den Schalter in den zweiten Leitungszustand versetzt, um den Fluss in einen linearen Bereich einer BH-Hystereseschleife des Kerns zu reduzieren.

13. System gemäß Anspruch 11, wobei die Messspule einen quadratischen Schleifenkern oder einen amorphen Metallkern umfasst.

14. System gemäß Anspruch 11, wobei der geschlossene Kern einen linearen Kern oder einen runden Schleifenkern umfasst.

15. System gemäß Anspruch 11, wobei der Steuerungsschaltkreis einen monopolaren Messschaltkreis umfasst, der eingerichtet ist, um einen Strom nur in einem positiven oder negativen Teil einer Wellenform eines Wechselstroms durch den Leiter zu messen, oder wobei der Steuerungsschaltkreis einen bipolaren Messschaltkreis umfasst, der eingerichtet ist, um einen Strom in sowohl positiven und negativen Teilen einer Wellenform eines Wechselstroms durch den Leiter zu messen.

## Revendications

1. Procédé de détection d'un courant traversant un conducteur comprenant :
a) la commutation d'un circuit de commande pour permettre à un courant primaire traversant le conducteur de créer un flux dans un noyau fermé d'une bobine de détection incluant un niveau de flux qui sature le noyau, dans lequel le noyau peut être amené en saturation et hors saturation et dans lequel le noyau comporte une boucle d'hystérésis BH ;
b) la commutation du circuit de commande pour diminuer le flux en dessous d'un niveau de mesure désiré qui ne sature pas le noyau pour autoriser un courant secondaire à traverser la bobine de détection, qui est proportionnel au courant primaire ;
c) la détection d'une valeur représentative du courant traversant la bobine de détection comprenant les étapes consistant à :
déterminer un niveau de courant à détecter ; et
en se basant sur le niveau de courant, mettre en oeuvre un premier algorithme de détection de courant ou un second algorithme de détection de courant ; et
d) transformer une valeur représentative du courant traversant la bobine de détection en une valeur représentative du courant traversant le conducteur,
dans lequel le premier algorithme de détection de courant comprend l'actionnement par une saturation alimentée du noyau, et
dans lequel le second algorithme de détection de courant comprend l'actionnement par une saturation non alimentée du noyau, dans lequel la saturation non alimentée est obtenue dans le cas où le courant primaire est suffisamment grand pour amener le noyau en saturation et dans lequel la saturation alimentée est obtenue en forçant la saturation du noyau, dans le cas d'un faible courant primaire.

2. Procédé selon la revendication 1, dans lequel, à l'étape (b), le flux est réduit dans une plage linéaire d'une boucle d'hystérésis BH du noyau.

3. Procédé selon la revendication 1, comprenant la répétition des étapes (a), (b) et (c) pour détecter périodiquement le courant traversant la bobine de détection.

4. Procédé selon la revendication 1, comprenant la conversion du courant détecté en une valeur numérique dans un convertisseur analogique-numérique, et dans lequel les étapes (a), (b) et (c) sont exécutées en une durée inférieure à la fréquence d'échantillonnage du convertisseur analogique-numérique, dans lequel la fréquence d'échantillonnage est au moins approximativement de 1 kHz.

5. Procédé selon la revendication 1, dans lequel le circuit de commande est commuté pour permettre au courant primaire traversant le conducteur de saturer le noyau seulement pendant une partie d'une période d'une forme d'onde de courant périodique traversant le conducteur.

6. Procédé selon la revendication 1, dans lequel le noyau fermé comprend un noyau en boucle carrée, ou dans lequel le noyau fermé comprend un noyau linéaire ou dans lequel le noyau fermé comprend un noyau en boucle circulaire ou dans lequel le noyau en boucle fermée comprend un noyau en métal amorphe.

7. Procédé selon la revendication 1,
dans lequel le circuit de commande comprend un circuit de détection monopolaire et dans lequel le courant est détecté sur une seule d'une partie positive ou d'une partie négative d'une forme d'onde ou sur un courant alternatif traversant le conducteur ; ou
dans lequel le circuit de commande comprend un circuit de détection bipolaire, et dans lequel le courant est détecté à la fois pendant les parties positives et négatives d'une forme d'onde de courant alternatif traversant le conducteur, et comprenant en outre le changement des états conducteurs de paires de commutateurs à l'état solide du circuit de détection bipolaire selon que la forme d'onde est dans une partie positive ou une partie négative.

8. Procédé selon la revendication 1, dans lequel le courant à détecter traversant le conducteur comprend un courant alternatif, ou dans lequel le courant à détecter traversant le conducteur comprend une période variable, ou dans lequel le courant à détecter traversant le conducteur comprend un courant continu.

9. Procédé selon la revendication 1, dans lequel le second algorithme de détection de courant comprend la commutation d'un circuit de commande pour permettre à un courant primaire traversant le conducteur de créer un flux dans un noyau fermé d'une bobine de détection qui sature le noyau, la commutation du circuit de commande pour modifier le flux, la détection d'une valeur représentative du courant traversant la bobine de détection pendant que le flux est modifié, et la transformation d'une valeur représentative du courant traversant la bobine de détection en une valeur représentative du courant traversant le conducteur.

10. Procédé selon la revendication 9, dans lequel le second algorithme de détection de courant est mis en oeuvre pour des niveaux de courant supérieurs aux niveaux pour lesquels le premier algorithme de détection est mis en oeuvre, et/ou dans lequel au moins le second algorithme de détection de courant est mis en oeuvre à la fois pour des courants continus et des courants alternatifs.

11. Système de détection d'un courant traversant un conducteur comprenant :
une bobine de détection enroulée autour d'un noyau fermé configuré pour recevoir le conducteur à travers celui-ci, dans lequel le noyau formé possède une hystérésis BH ;
des circuits de commande couplée à la bobine de détection et comprenant au moins un commutateur, les circuits de commande étant configurés pour mettre le commutateur dans un premier état conducteur pour permettre à un courant primaire traversant le conducteur de créer un flux qui sature le noyau, et pour modifier l'état du commutateur pour amener le noyau hors saturation ; et
des circuits de mesure couplés aux circuits de commande et configurés pour générer un signal représentatif du courant traversant la bobine de détection,
dans lequel le système est configuré en outre pour déterminer un niveau de courant à détecter ; et en se basant sur le niveau de courant, mettre en oeuvre un premier algorithme de détection de courant ou un second algorithme de détection de courant, dans lequel le premier algorithme de détection de courant comprend l'actionnement par une saturation alimentée du noyau, et dans lequel le second algorithme de détection de courant comprend l'actionnement par une saturation non alimentée du noyau, dans lequel la saturation non alimentée est obtenue dans le cas où le courant primaire est suffisamment grand pour amener le noyau en saturation et dans lequel la saturation alimentée est obtenue en forçant la saturation du noyau, dans le cas d'un faible courant primaire.

12. Système selon la revendication 11, dans lequel les circuits de commande mettent le commutateur dans le second état conducteur pour diminuer le flux dans une plage linéaire d'une boucle d'hystérésis BH du noyau.

13. Système selon la revendication 11, dans lequel la bobine de détection comprend un noyau en boucle carrée, ou dans lequel la bobine de détection comprend un noyau en métal amorphe.

14. Système selon la revendication 11, dans lequel le noyau fermé comprend un noyau linéaire, ou dans lequel le noyau fermé comprend un noyau en boucle circulaire.

15. Système selon la revendication 11, dans lequel les circuits de commande comprennent un circuit de détection monopolaire configuré pour détecter le courant sur une seule d'une partie positive ou d'une partie négative d'une forme d'onde ou d'un courant alternatif traversant le conducteur ; ou dans lequel les circuits de commande comprennent un circuit de détection bipolaire configuré pour détecter le courant à la fois pendant les parties positives et négatives d'une forme d'onde de courant alternatif traversant le conducteur.
